# EUROPEAN PATENT APPLICATION

(11) **EP 4 783 406 A1**
(43) Date of publication of application: **29.07.2026**
(21) Application number: 25793212.9
(22) Date of filing: 24.02.2025
(51) Int. Cl.: H02J 7/00, G01R 35/00

(54) **ELECTRONIC DEVICE, CALIBRATION SYSTEM, AND CONTROL METHOD**

(30) Priority: 25.04.2024 CN 202410511912
(71) Applicant: HUAWEI TECHNOLOGIES CO., LTD., Shenzhen 518129 (CN)
(72) Inventor: XU, Tianqi, Shenzhen, Guangdong 518129 (CN); LI, Shuai, Shenzhen, Guangdong 518129 (CN); MO, Jiaqing, Shenzhen, Guangdong 518129 (CN); QIN, Huawei, Shenzhen, Guangdong 518129 (CN)
(74) Representative: Maiwald GmbH
(86) International application number: PCT/CN2025/078777
(87) International publication number: WO 2025/223014

(57) **Abstract**

This application provides an electronic device, a calibration system, and a control method. A charging module, a battery module, a collection module, and a control module are included. The charging module is configured to provide a total charging current for the battery module. The battery module includes a first cell and a second cell that are connected in parallel. The collection module includes a first collection module and a second collection module, where the first collection module is configured to obtain a charging current of the first cell, and the second collection module is configured to obtain a charging current of the second cell or the total charging current. The control module is configured to control, based on charging currents collected by the collection module, the total charging current provided by the charging module. This application provides the electronic device, the calibration system, and the control method, so that charging safety of each cell can be ensured while charging efficiency is improved.

## Description

This application claims priority to Chinese Patent Application No. 202410511912.9, filed with the China National Intellectual Property Administration on April 25, 2024 and entitled "ELECTRONIC DEVICE, CALIBRATION SYSTEM, AND CONTROL METHOD", which is incorporated herein by reference in its entirety.

### TECHNICAL FIELD

This application relates to the circuit field, and more specifically, to an electronic device, a calibration system, and a control method.

### BACKGROUND

With continuous development of electronic devices such as mobile phone terminals, tablet computers, and personal computers, people have gradually increasing requirements for a battery life of the electronic device. However, actual internal space of the electronic device is limited. To arrange a battery with a larger capacity in the limited space, a plurality of cells may be coupled in parallel and packaged into one battery. Internal resistance characteristics of different cells are different. As a result, when the electronic device is charged, charging currents obtained by the different cells are different, and safety thresholds of the charging currents of the different cells are also different. When the electronic device is charged based on a specific total charging current, a cell with a weak charging capability has a risk that a charging current exceeds a safety threshold.

Therefore, how to ensure charging safety while arranging a battery with a larger capacity is an urgent problem to be resolved currently.

### SUMMARY

This application provides an electronic device, a calibration system, and a control method, so that charging safety can be ensured while a battery with a larger capacity is arranged.

According to a first aspect, an electronic device is provided, including: a charging module, where the charging module is connected to a first end of a battery module and is configured to provide a total charging current for the battery module; the battery module, including a first branch and a second branch, where the first branch is connected in parallel to the second branch, the first branch includes a first cell and a first resistor that are connected in series, and the second branch includes a second cell; a collection module, where the collection module includes a first collection module and a second collection module, the first collection module is connected in parallel to the first resistor to obtain a first current, the first current is a charging current of the first cell, the second collection module is configured to obtain a second current, and the second current is a charging current of the second cell or the total charging current; and a control module, connected to the charging module and configured to control, based on the first current and the second current, the total charging current provided by the charging module.

The first resistor may be a collection resistor, and a current passing through the first resistor is the charging current of the first cell.

Based on the foregoing solution, a plurality of cells connected in parallel may be disposed in the battery module in the electronic device, so that a battery capacity can be improved. The collection module in the electronic device may obtain a charging current of each cell, and the control module may control, based on the charging current of each cell, the total charging current provided by the charging module, to ensure charging safety of each cell when the electronic device is charged.

With reference to the first aspect, in some implementations of the first aspect, the battery module further includes a second resistor, both a first end of the first branch and a first end of the second branch are connected to a first end of the second resistor, a second end of the second resistor is grounded, the second collection module is connected in parallel to the second resistor, and the second current is the total charging current.

The second resistor may be a collection resistor, and a current passing through the second resistor is the total charging current of the battery module.

Based on the foregoing solution, if the battery module includes N (N is a positive integer greater than or equal to 2) cells, a charging current of each cell in the battery module may be determined by obtaining a total charging current of the battery module and respectively obtaining charging currents of N-1 cells of the battery module, to ensure charging safety of each cell.

With reference to the first aspect, in some implementations of the first aspect, the second branch further includes a third resistor connected in series to the second cell, the second collection module is connected in parallel to the third resistor, and the second current is the charging current of the second cell.

Based on the foregoing solution, the charging current of each cell may be directly obtained, to ensure charging safety of each cell.

With reference to the first aspect, in some implementations of the first aspect, the control module is connected to the collection module to obtain the first current and the second current; and the control module is specifically configured to control, based on the charging current of the first cell and the charging current of the second cell, the total charging current provided by the charging module.

The control module stores a current threshold of the first cell and a current threshold of the second cell. The current threshold of the first cell is a safety threshold of the first cell, and may be understood as a maximum charging current value of the first cell; and the current threshold of the second cell is a safety threshold of the second cell, and may be understood as a maximum charging current value of the second cell. The control module may determine whether the charging current of the first cell exceeds the safety threshold of the first cell, and may also determine whether the charging current of the second cell exceeds the safety threshold of the second cell.

Based on the foregoing solution, the control module determines the charging current of each cell in the battery module and a safety threshold of the cell, to ensure charging safety of each cell in the battery module.

With reference to the first aspect, in some implementations of the first aspect, when the control module determines that the charging current of the first cell is greater than a first current threshold and the charging current of the second cell is less than or equal to a second current threshold, the control module is specifically configured to control the charging module to reduce the total charging current; when the control module determines that the charging current of the first cell is less than or equal to a first current threshold and the charging current of the second cell is greater than a second current threshold, the control module is specifically configured to control the charging module to reduce the total charging current; or when the control module determines that the charging current of the first cell is greater than a first current threshold and the charging current of the second cell is greater than a second current threshold, the control module is specifically configured to control the charging module to reduce the total charging current.

Based on the foregoing solution, when the control module determines that a charging current of any cell in the battery module exceeds a safe current, the control module controls the charging module to reduce the total charging current, so that charging safety of each cell in the battery module can be ensured.

With reference to the first aspect, in some implementations of the first aspect, when the control module determines that the charging current of the first cell is less than the first current threshold and the charging current of the second cell is less than the second current threshold, the control module is specifically configured to control the charging module to increase the total charging current.

Based on the foregoing solution, when charging currents of the cells are respectively less than safety thresholds, the control module may control an increase of the total charging current, to improve charging efficiency.

With reference to the first aspect, in some implementations of the first aspect, the battery module further includes at least one third branch, each of the at least one third branch includes a third cell and a fourth resistor that are connected in series, and the third branch is connected in parallel to the first branch and is connected in parallel to the second branch; the collection module further includes a third collection module, the third collection module is connected in parallel to the fourth resistor to obtain a third current, and the third current is a charging current of the third cell; and the control module is configured to control, based on the first current, the second current, and the third current, the total charging current provided by the charging module.

Based on the foregoing solution, more cells connected in parallel may be arranged based on actual internal space of the electronic device, to obtain a larger battery capacity.

With reference to the first aspect, in some implementations of the first aspect, the control module is connected to the collection module to obtain the first current, the second current, and the third current; and the control module is specifically configured to control, based on the charging current of the first cell, the charging current of the second cell, and the charging current of the third cell, the total charging current provided by the charging module.

Based on the foregoing solution, the control module determines the charging current of each cell in the battery module and a safety threshold of the cell, to ensure charging safety of each cell in the battery module.

With reference to the first aspect, in some implementations of the first aspect, the electronic device further includes a discharging module, the discharging module is connected to the charging module and is connected to the control module, and the discharging module is configured to supply power to the electronic device.

With reference to the first aspect, in some implementations of the first aspect, the battery module includes a first region and a second region, the first region is used for disposing the first cell, the second region is used for disposing the second cell, and a size of the first cell is different from a size of the second cell, to form a vacant region in the electronic device.

Based on the foregoing solution, a plurality of cells of different sizes may be arranged in the electronic device, so that a greater quantity of cells are arranged in the limited internal space of the electronic device, and specific room may also be made for another hardware apparatus.

According to a second aspect, a calibration system is provided, including: an electronic device, where the electronic device includes a collection module, and the collection module includes a first collection module and a second collection module; and a calibration module, where the calibration module includes a first calibration circuit and a second calibration circuit, the first calibration circuit includes a calibration power supply and a fifth resistor that are connected in series, the second calibration circuit includes the calibration power supply and a sixth resistor that are connected in series, the second calibration circuit is connected in parallel to the first calibration circuit, and the calibration power supply is configured to provide a calibration current; and the first collection module is connected in parallel to the fifth resistor to obtain a loop current of the first calibration circuit, and the second collection module is connected in parallel to the sixth resistor to obtain a loop current of the second calibration circuit.

The fifth resistor and the sixth resistor may be collection resistors. A current passing through the fifth resistor is the loop current of the first calibration circuit, and a current passing through the sixth resistor is the loop current of the second calibration circuit.

Based on the foregoing solution, a calibration module in the electronic device may calibrate submodules (including the first collection module and the second collection module) in the collection module. Specifically, the first collection module and the second collection module may be respectively calibrated by using loop currents in calibration circuits of the calibration module.

With reference to the second aspect, in some implementations of the second aspect, the calibration module further includes a controller, the controller is configured to determine a first calibration coefficient based on the loop current of the first calibration circuit and the calibration current, and is further configured to determine a second calibration coefficient based on the loop current of the second calibration circuit and the calibration current.

The controller may be a PC controller, and a calibration current is provided by the calibration power supply. The PC controller calibrates, based on the calibration current, the loop current of the first calibration circuit obtained by the first collection module, and obtains the first calibration coefficient, to calibrate the first collection module; and calibrates, based on the calibration current, the loop current of the second calibration circuit obtained by the second collection module, and obtains the second calibration coefficient, to calibrate the second collection module.

Based on the foregoing solution, the controller of the calibration module may calibrate the submodules in the collection module, so that the submodules in the collection module can more accurately obtain charging currents of cells in the electronic device.

With reference to the second aspect, in some implementations of the second aspect, a control module is included. The control module is connected to the collection module and is configured to obtain the loop current of the first calibration circuit and the loop current of the second calibration circuit; and the controller is connected to the control module to obtain the loop current of the first calibration circuit and the loop current of the second calibration circuit through the control module.

The control module is connected to the collection module, and may obtain the loop current of the first calibration circuit and the loop current of the second calibration circuit, and transmit the loop current of the first calibration circuit and the loop current of the second calibration circuit to the controller, so that the controller separately calibrates the first collection module and the second collection module based on the loop current of the first calibration circuit, the loop current of the second calibration circuit, and the calibration current.

Based on the foregoing solution, the control module transmits the loop currents of the calibration circuits to the controller, so that the controller calibrates the collection module.

With reference to the second aspect, in some implementations of the second aspect, the controller is further configured to transmit the first calibration coefficient and the second calibration coefficient to the control module; and the control module is further configured to store the first calibration coefficient and the second calibration coefficient, the first calibration coefficient is used to calibrate a first current, the first current is a charging current of a first cell, the second calibration coefficient is used to calibrate a second current, and the second current is a charging current of a second cell or a total charging current of the electronic device.

Based on the foregoing solution, the control module may more accurately determine a charging current of each cell based on the calibration coefficient, to determine charging safety of each cell.

With reference to the second aspect, in some implementations of the second aspect, the first calibration circuit further includes a first transistor, the first transistor is connected in series to the calibration power supply and the fifth resistor, and the first transistor is configured to control the first calibration circuit to be disconnected or connected; the second calibration circuit further includes a second transistor, the second transistor is connected in series to the calibration power supply and the sixth resistor, and the second transistor is configured to control the second calibration circuit to be disconnected or connected; and when the first transistor controls the first calibration circuit to be connected and the second transistor controls the second calibration circuit to be disconnected, the controller is specifically configured to determine the first calibration coefficient based on the loop current of the first calibration circuit and the calibration current; or when the first transistor controls the first calibration circuit to be disconnected and the second transistor controls the second calibration circuit to be connected, the controller is specifically configured to determine the second calibration coefficient based on the loop current of the second calibration circuit and the calibration current.

Based on the foregoing solution, a transistor may control a calibration circuit to be connected or disconnected, so that the controller separately calibrates the first collection module and the second collection module.

With reference to the second aspect, in some implementations of the second aspect, the first calibration circuit further includes a seventh resistor, the seventh resistor is connected in series to the calibration power supply, the fifth resistor, and the first transistor, and the seventh resistor is configured to adjust the loop current of the first calibration circuit; and the second calibration circuit further includes an eighth resistor, the eighth resistor is connected in series to the calibration power supply, the sixth resistor, and the second transistor, and the eighth resistor is configured to adjust the loop current of the second calibration circuit.

Based on the foregoing solution, a resistor configured to adjust a loop current may be disposed on a calibration circuit, so that the collection module more accurately obtains the loop current of the calibration circuit.

According to a third aspect, a control method is provided. The method may be applied to an electronic device, the electronic device includes at least two cells connected in parallel, the at least two cells include a first cell and a second cell, and the method includes: determining a charging current of the first cell and a charging current of the second cell; and controlling a total charging current of the electronic device and the total charging current of the electronic device based on the charging current of the first cell and/or the charging current of the second cell.

Based on the foregoing solution, the total charging current of the electronic device may be controlled based on a charging current of each cell in the electronic device, to ensure charging safety of each cell.

With reference to the third aspect, in some implementations of the third aspect, determining the charging current of the first cell and the charging current of the second cell includes: obtaining a total charging current of the at least two cells and the charging current of the first cell; and determining the charging current of the second cell based on the total charging current of the at least two cells and the charging current of the first cell.

It should be noted that, if a battery module includes N (N is a positive integer greater than or equal to 2) cells, a total charging current of the N cells and charging currents of N-1 cells may be obtained, to determine charging currents of all the cells in the battery module.

For example, the charging current of each cell in the battery module may be determined based on charging currents of two cells and a charging current of one of the cells.

With reference to the third aspect, in some implementations of the third aspect, determining the charging current of the first cell and the charging current of the second cell includes: obtaining the charging current of the first cell and the charging current of the second cell.

It should be noted that, if a battery module includes N (N is a positive integer greater than or equal to 2) cells, charging currents of N cells may be separately obtained.

With reference to the third aspect, in some implementations of the third aspect, controlling the total charging current of the electronic device based on the charging current of the first cell and/or the charging current of the second cell includes: when the charging current of the first cell is greater than a first current threshold and the charging current of the second cell is less than or equal to a second current threshold, reducing the total charging current of the electronic device; when the charging current of the first cell is less than or equal to a first current threshold and the charging current of the second cell is greater than a second current threshold, reducing the total charging current of the electronic device; or when the charging current of the first cell is greater than a first current threshold and the charging current of the second cell is greater than a second current threshold, reducing the total charging current.

It should be noted that, the first current threshold is a current threshold of the first cell, namely, a safety threshold of the first cell, and the second current threshold is a current threshold of the second cell, namely, a safety threshold of the second cell. When a charging current of a cell exceeds a safety threshold, a safety risk exists.

Based on the foregoing solution, when a charging current of any one of a plurality of cells in the electronic device exceeds a safety threshold, the total charging current of the electronic device may be reduced, to ensure charging safety of each cell in the electronic device.

With reference to the third aspect, in some implementations of the third aspect, controlling the total charging current of the electronic device based on the charging current of the first cell and/or the charging current of the second cell includes: when the charging current of the first cell is less than the first current threshold and the charging current of the second cell is less than the second current threshold, increasing the total charging current.

Based on the foregoing solution, when the cells in the electronic device are respectively within safety thresholds, the total charging current of the electronic device may be increased, to improve charging efficiency.

According to a fourth aspect, a computer-readable storage medium is provided. The computer-readable storage medium stores a computer program, and when the computer program is run on a computer, the computer is enabled to perform the method according to any one of the third aspect and the possible implementations of the third aspect.

According to a fifth aspect, a computer program product including instructions is provided. When the computer program product is run on a computer, the computer is enabled to perform the method according to any one of the third aspect and the possible implementations of the third aspect.

According to a sixth aspect, a chip is provided. The chip includes a processor and a data interface. The processor reads, through the data interface, instructions stored in a memory, to perform the method according to any one of the third aspect and the possible implementations of the third aspect.

### BRIEF DESCRIPTION OF DRAWINGS

FIG. 1 is a diagram of a structure of an electronic device;
FIG. 2 is a schematic plan view of internal space of an electronic device;
FIG. 3 is a diagram of a system architecture according to an embodiment of this application;
FIG. 4(a) and FIG. 4(b) are diagrams of an electronic device and a calibration system according to an embodiment of this application;
FIG. 5 is a diagram of a structure of an electronic device according to an embodiment of this application;
FIG. 6 is a diagram of a structure of an electronic device according to an embodiment of this application;
FIG. 7 is a schematic flowchart of a control method according to an embodiment of this application;
FIG. 8 is a diagram of a structure of a calibration system according to an embodiment of this application; and
FIG. 9 is a diagram of a structure of a calibration system according to an embodiment of this application.

### DESCRIPTION OF EMBODIMENTS

To make objectives, technical solutions, and advantages of this application clearer, the following clearly describes the technical solutions in this application with reference to the accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. Words similar to "connect", "connected", and the like are used to express interworking or mutual interaction between different components, and may include a connection, a direct connection, an indirect connection through another component, and the like. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device.

It should be understood that, in this application, "at least one (item)" means one or more, and "a plurality of" means two or more. "And/or" is used for describing an association relationship between associated objects and indicates that three relationships may exist. For example, "A and/or B" may indicate the following three cases: Only A exists, only B exists, and both A and B exist, where A and B may be singular or plural. The character "/" usually indicates an "or" relationship between the associated objects. "At least one of the following items (pieces)" or a similar expression thereof means any combination of these items, including a single item (piece) or any combination of a plurality of items (pieces). For example, at least one item (piece) of a, b, or c may indicate a, b, c, "a and b", "a and c", "b and c", or "a, b, and c", where a, b, and c may be singular or plural.

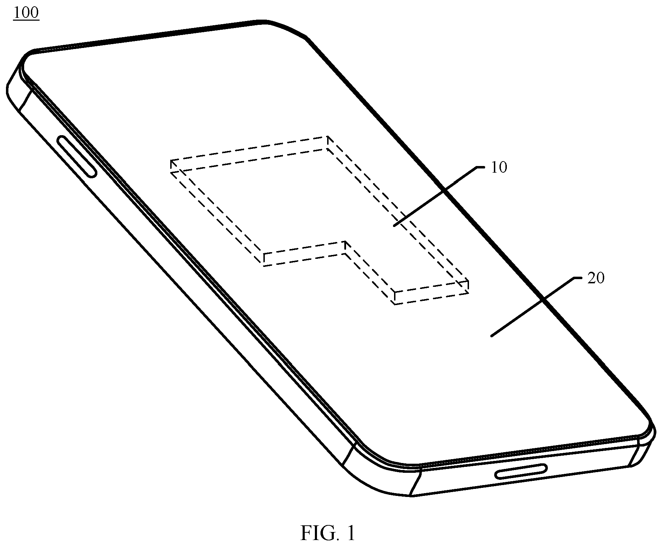

FIG. 1 is a diagram of a structure of an electronic device 100 according to an embodiment of this application. The electronic device 100 may be, for example, a terminal consumer product or a 3C electronic product (a computer (computer), communication (communication), or consumer (consumer) electronic product), for example, a device such as a mobile phone, a mobile power supply, a portable computer, a tablet computer, an e-reader, a notebook computer, a digital camera, a wearable device, a vehicle-mounted terminal, or a headset. The electronic device 100 may alternatively be, for example, a mobile apparatus. The mobile apparatus may be, for example, a vehicle, an electric skateboard, or an electric bicycle. In the embodiment shown in FIG. 1, an example in which the electronic device 100 is a mobile phone is used for description.

An interior of the electronic device 100 includes a battery 10 and another region 20 other than the battery. The battery 10 may be, for example, a lithium-electron secondary battery, a sodium-ion secondary battery, a potassium-ion secondary battery, a magnesium-ion secondary battery, a zinc-ion secondary battery, or an aluminum-ion secondary battery. The battery 10 may provide electric energy for the electronic device 100. The battery 10 may include one or more cells. Arranging a greater quantity of cells or cells with a larger individual capacity in limited space of the battery 10 can maximize electric energy provided for the electronic device 100. In addition, because internal space of the electronic device 100 is limited, a layout of a plurality of cells in the battery 10 minimizes space that the cells occupy, to make room for the another region 20. In this way, a mainboard of the electronic device 100 may be arranged in the another region.

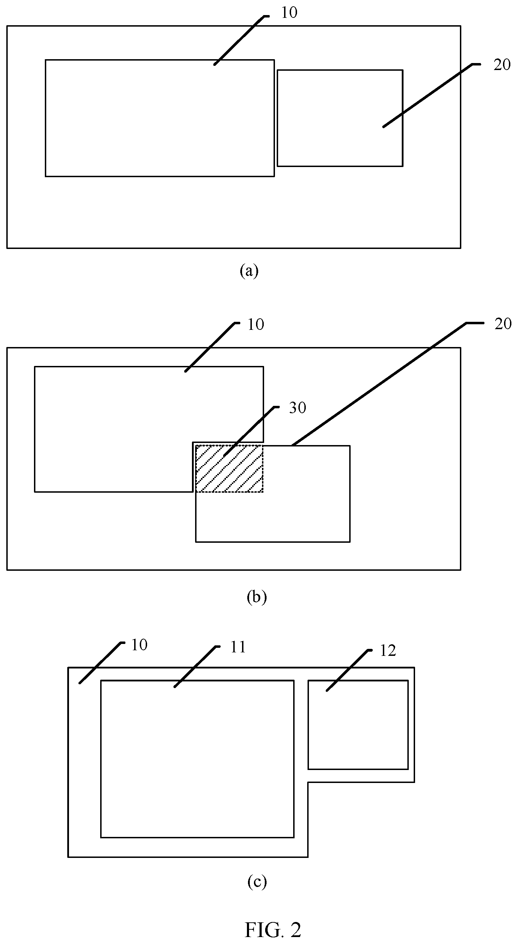

For ease of understanding, with reference to FIG. 2, the following shows an example of space occupied by the battery 10 and the another region 20.

FIG. 2 is a schematic plan view of internal space of an electronic device according to an embodiment of this application.

As shown in (a) in FIG. 2, the electronic device includes a battery 10 and another region 20 inside. The battery 10 is a regular rectangle. To save the internal space of the electronic device, the another region 20 (for example, a mainboard) is distributed close to the battery 10.

On a premise that the battery 10 provides same electric energy, a diagram of an internal layout of the electronic device shown in (b) in FIG. 2 may be obtained by optimizing sizes and a layout of cells in the battery 10.

As shown in (b) in FIG. 2, the electronic device includes a battery 10 and another region 20 inside. A shape of the battery 10 is irregular. In comparison with that in (a) in FIG. 2, an area occupied by a vacant region 30 shown by a shadow is saved. In this way, the another region 20 may use the space domain region 30 to arrange a mainboard or another hardware apparatus of the electronic device.

It should be noted that, a plurality of cells may be arranged in the battery 10, the plurality of cells may be connected in parallel, and sizes or capacities of the plurality of cells may also be different. For example, as shown in (c) in FIG. 2, the battery 10 includes a first region and a second region, where the first region is a region for disposing a cell 11, and the second region is a region for disposing a cell 12. The cell 11 and the cell 12 have different sizes. It is clear that a size of the cell 12 is smaller than that of the cell 11. To save space of the battery 10, a shape of the battery 10 may be designed along size boundaries of the battery 11 and the battery 12, and does not need to be set to be a regular rectangle. In this way, room of the vacant region 30 shown in (b) in FIG. 2 may be made for another hardware apparatus.

To supply power to the electronic device, a battery with a larger capacity needs to be disposed in the limited space of the electronic device, and a plurality of cells of different sizes and different capacities may be disposed inside the battery. However, in practice, different cells have different internal resistance characteristics. As a result, when the electronic device is charged, charging currents obtained by the different cells are different. In addition, because safety thresholds of the charging currents of the different cells are also different, when the electronic device is charged based on a specific total charging current, a cell with a low safety threshold is more likely to have a risk of charging overcurrent.

Therefore, embodiments of this application provide an electronic device, a calibration system, and a control method, so that more cells can be arranged in limited space. In addition, when a plurality of cells connected in parallel are charged, charging currents of the cells may be separately detected, to ensure that the plurality of cells are charged based on maximum currents within safety thresholds of the cells, thereby maximizing charging efficiency.

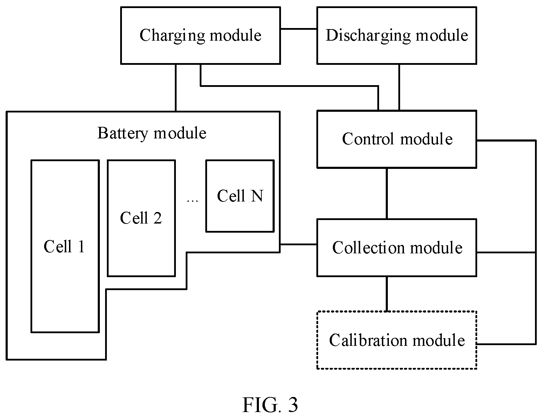

FIG. 3 is a diagram of a system architecture according to an embodiment of this application. The system architecture may include a charging module, a control module, a collection module, a calibration module, a battery module, and a discharging module.

Specifically, the charging module is configured to charge the battery module, and may supply, to an electronic device through the discharging module, electric energy input by the charging module. The battery module may include a plurality of cells, for example, a cell 1, a cell 2, ..., and a cell N. The plurality of cells may be connected in parallel, and sizes and capacities of the plurality of cells may be different. The plurality of cells of different sizes or different capacities make a shape of the battery module not a regular rectangle. That is, a shape of a battery pack of the electronic device may change with parameters such as a quantity, a size, and a capacity of an internal cell, so that the battery pack can flexibly adapt to internal space of the electronic device and make specific room for another hardware apparatus.

When the charging module charges the battery module, the collection module may obtain a charging current of each cell in the battery module. The control module may determine, based on the charging current obtained by the collection module, whether the charging current exceeds a safety threshold of each cell in the battery module, and control, based on whether the charging current exceeds the safety threshold, a total charging current provided by the charging module for the battery module. In addition, to ensure that the control module can accurately determine whether the charging current of each cell exceeds the safety threshold, the charging current obtained by the collection module may be calibrated by the calibration module.

Optionally, before the electronic device is delivered from a factory, a system architecture of the electronic device may include the foregoing charging module, control module, collection module, and calibration module. The collection module may include a plurality of voltameters configured to obtain charging currents of different cells. The calibration module may calibrate the voltameter in the collection module to obtain a calibration coefficient, so that accuracy of a charging current of each cell subsequently obtained through the collection module is high.

Optionally, in a scenario in which a user charges the electronic device after the electronic device is delivered from the factory, the system architecture of the electronic device may include the foregoing charging module, control module, collection module, and battery module. When the charging module provides a total charging current for the battery module, the collection module obtains a charging current of each cell in the battery module, the control module determines whether the charging current of each cell is within a safety threshold, and if the charging current exceeds the safety threshold, the control module indicates the charging module to control the total charging current. In this way, charging efficiency is maximized while charging safety is ensured. In addition, to further improve accuracy of the obtained charging current of each cell, the control module of the electronic device after delivery may store the calibration coefficient obtained through calibration before delivery, to more accurately determine, based on the calibration coefficient, whether the total charging current needs to be controlled, and more accurately control the total charging current.

With reference to the accompanying drawings, the following specifically describes an electronic device, a calibration system, and a control method that are provided in embodiments of this application.

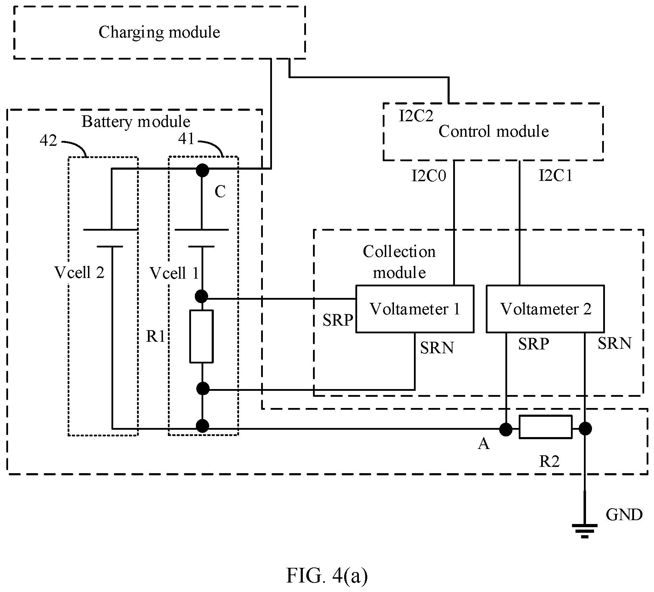

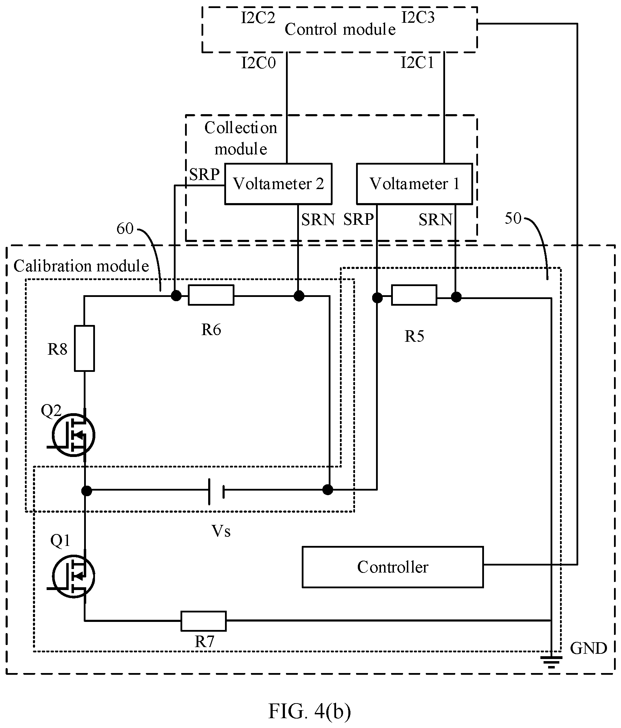

FIG. 4(a) and FIG. 4(b) are diagrams of an electronic device and a calibration system according to an embodiment of this application.

FIG. 4(a) is a diagram of a structure of an electronic device. The diagram shows a structure of an electronic device after delivery. By using the electronic device, a charging current of each cell can be obtained, and charging efficiency can be maximized while charging safety is ensured based on the charging current of each cell.

The electronic device includes a charging module, a battery module, a collection module, and a control module.

The charging module is connected to a first end (end C) of the battery module and is configured to provide a total charging current for the battery module.

The battery module includes a first branch 41 and a second branch 42. The first branch 41 is connected in parallel to the second branch 42, the first branch 41 includes a first cell Vcell 1 and a first resistor R1 that are connected in series, and the second branch 42 includes a second cell Vcell 2.

The collection module includes a first collection module and a second collection module. The first collection module is connected in parallel to the first resistor R1 to obtain a first current. The first current is a charging current of the first cell Vcell 1. The second collection module is configured to obtain a second current.

The control module is connected to the charging module and is configured to control, based on the first current and the second current, the total charging current provided by the charging module.

Optionally, the battery module further includes a second resistor R2. A first end (end A) of the first branch 41 and a first end (end A) of the second branch 42 are connected to a first end of the second resistor R2, a second end of the second resistor R2 is grounded, the second collection module is connected in parallel to the second resistor R2, and the second current is the total charging current.

It may be understood that a battery pack in the electronic device may include all or some components in the battery module. This is not limited in this application.

For example, the second resistor R2 may belong to the battery pack, or may be outside the battery pack and externally connected to the battery pack.

It should be noted that the first resistor R1 and the second resistor R2 may be collection resistors. A current passing through the first resistor R1 is the charging current of the first cell Vcell 1, and a current passing through the second resistor R2 is the total charging current of the battery module, including the charging current of the first cell Vcell 1 and the charging current of the second cell Vcell 2.

For example, the first collection module is a voltameter 1, and the second collection module is a voltameter 2. The voltameter 1 is connected in parallel to the first resistor R1 through an SRP pin and an SRN pin to obtain the current passing through the second resistor R1. The voltameter 2 is connected in parallel to the second resistor R2 through an SRP pin and an SRN pin to obtain the current passing through the first resistor R2.

The control module is connected to the collection module to obtain the first current and the second current. The control module is specifically configured to control, based on the charging current of the first cell Vcell 1 and the charging current of the second cell Vcell 2, the total charging current provided by the charging module.

For example, the control module is connected to the voltameter 1 through an I2C0 interface and is connected to the voltameter 2 through an I2C1 interface. The control module determines the current obtained by the voltameter 1 as the charging current of the first cell Vcell 1, and determines the charging current of the second cell Vcell 2 based on the current obtained by the voltameter 2 and the current obtained by the voltameter 1. The control module stores a current threshold of the first cell Vcell 1 and a current threshold of the second cell Vcell 2. The current threshold of the first cell Vcell 1 is a safety threshold of the first cell Vcell 1, and may be understood as a maximum charging current value of the first cell Vcell 1; and the current threshold of the second cell Vcell 2 is a safety threshold of the second cell Vcell 2, and may be understood as a maximum charging current value of the second cell Vcell 2. The control module may determine whether the charging current of the first cell Vcell 1 exceeds the safety threshold of the first cell Vcell 1, and determine whether the charging current of the second cell Vcell 2 exceeds the safety threshold of the second cell Vcell 2.

It should be noted that, the control module determines whether the charging current of each cell in the battery module exceeds a safety threshold of the cell, to maximize the total charging current of the battery module while ensuring charging safety of each cell in the battery module, thereby improving charging efficiency.

When the control module determines that the charging current of the first cell Vcell 1 is greater than a first current threshold and the charging current of the second cell Vcell 2 is less than or equal to a second current threshold, the control module is specifically configured to control the charging module to reduce the total charging current. When the control module determines that the charging current of the first cell Vcell 1 is less than or equal to a first current threshold and the charging current of the second cell Vcell 2 is greater than a second current threshold, the control module is specifically configured to control the charging module to reduce the total charging current. When the control module determines that the charging current of the first cell Vcell 1 is greater than a first current threshold and the charging current of the second cell Vcell 2 is greater than a second current threshold, the control module is specifically configured to control the charging module to reduce the total charging current.

For example, it is assumed that the first current threshold is 7 A, the second current threshold is 10 A, the current charging current of the first cell Vcell 1 is 8 A, and the current charging current of the second cell Vcell 2 is 6 A. The control module determines that the charging current of the first cell Vcell 1 is greater than the first current threshold and the charging current of the second cell Vcell 2 is less than the second current threshold. In this case, a ratio of an actual charging current of the first cell Vcell 1 to an actual charging current of the second cell Vcell 2 is 4/3 (8:6), and the total charging current is 14 A (8 A+6 A). To ensure charging safety, the actual charging current of the first cell Vcell 1 needs to be reduced to below the first current threshold 7 A. The control module may learn, through calculation based on the ratio of actual charging currents, that when the actual charging current of the first cell Vcell 1 is 7 A, the actual charging current of the second cell Vcell 2 is 5.25 A (6*7/8). In this case, the total charging current is 12.25 A (7 A+5.25 A). That is, the control module may control, based on the ratio of the charging currents of the cells, the total charging current to be reduced from 14 A to 12.25 A.

When the control module determines that the charging current of the first cell Vcell 1 is less than the first current threshold and the charging current of the second cell Vcell 2 is less than the second current threshold, the control module is specifically configured to control the charging module to increase the total charging current.

For example, it is assumed that the first current threshold is 7 A, the second current threshold is 10 A, the current charging current of the first cell Vcell 1 is 6 A, and the current charging current of the second cell Vcell 2 is 8 A. The control module determines that the charging current of the first cell Vcell 1 is less than the first current threshold and the charging current of the second cell Vcell 2 is less than the second current threshold. In this case, a ratio of an actual charging current of the first cell Vcell 1 to an actual charging current of the second cell Vcell 2 is 3/4 (6:8), and the total charging current is 14 A (8 A+6 A). The charging current of the first cell Vcell 1 is closer to the first current threshold. Therefore, to improve charging to be less than, a current value that needs to be increased for the actual charging current of the second cell Vcell 2 may be obtained through calculation based on a reference that the actual charging current of the first cell Vcell 1 needs to be increased to the first current threshold 7A. The control module learns, through calculation based on the ratio of actual charging currents, that when the actual charging current of the first cell Vcell 1 is 7 A, the actual charging current of the second cell Vcell 2 is 9.3 A (7*8/6). In this case, the total charging current is 16.3 A (7 A+9.3 A). That is, the control module may control, based on the ratio of the charging currents of the cells, the total charging current to be increased from 14 A to 16.3 A.

The first current threshold is the safety threshold of the first cell Vcell 1, and the second current threshold is the safety threshold of the second cell Vcell 2.

For example, the charging module is connected to the battery module to provide the total charging current, and is connected to an I2C2 interface of the control module to control the total charging current under control of the control module.

For example, when the control module determines that the charging current of the first cell Vcell 1 is greater than the safety threshold of the first cell Vcell 1, and/or the control module determines that the charging current of the second cell Vcell 2 is greater than the safety threshold of the second cell Vcell 2, the control module sends a control signal to the charging module, to control the charging module to reduce the total charging current, thereby ensuring charging safety. If the control module determines that the charging current of the first cell Vcell 1 is less than the safety threshold of the first cell Vcell 1, and the charging current of the second cell Vcell 2 is also less than the safety threshold of the second cell Vcell 2, the control module sends a control signal to the charging module, to control the charging module to increase the total charging current, thereby improving charging efficiency.

The electronic device provided in this embodiment of this application includes the battery module in which a plurality of cells are connected in parallel, and the collection module that can obtain the charging current of each cell, so that a battery with a larger capacity is disposed in limited internal space of the electronic device, and it can also be ensured that each cell is charged based on a maximum current within a safety threshold, thereby improving charging efficiency.

It can be learned that, in the electronic device shown in FIG. 4(a), the control module may control the total charging current based on the charging current of each cell. Further, a calibration coefficient may be introduced, and the control module may more accurately control, based on the calibration coefficient and the charging current of each cell, the total charging current provided by the charging module. The calibration coefficient may be usually obtained by calibrating the collection module by a calibration system before the electronic device is delivered from a factory. In the following, FIG. 4(b) is a diagram of a structure of a calibration system. Before the electronic device is delivered from the factory, the calibration coefficient may be obtained through calibration by the calibration system, so that the electronic device shown in FIG. 4(a) can more accurately control the total charging current based on the calibration coefficient.

The calibration system includes an electronic device and a calibration module, and the electronic device includes a collection module.

The collection module includes a first collection module and a second collection module. The calibration module includes a first calibration circuit 50 and a second calibration circuit 60. The first calibration circuit 50 includes a calibration power supply Vs and a fifth resistor R5 that are connected in series. The second calibration circuit 60 includes the calibration power supply Vs and a sixth resistor R6 that are connected in series. The second calibration circuit 60 is connected in parallel to the first calibration circuit 50. The calibration power supply Vs is configured to provide a calibration current. The first collection module is connected in parallel to the fifth resistor R5 to obtain a loop current of the first calibration circuit 50. The second collection module is connected in parallel to the sixth resistor R6 to obtain a loop current of the second calibration circuit 60.

It should be noted that the fifth resistor R5 and the sixth resistor R6 may be collection resistors. A current passing through the fifth resistor R5 is the loop current of the first calibration circuit 50, and a current passing through the sixth resistor R6 is the loop current of the second calibration circuit 60.

For example, the first collection module is a voltameter 1, and the second collection module is a voltameter 2. The voltameter 1 is connected in parallel to the fifth resistor R5 through an SRP pin and an SRN pin to obtain the current passing through the fifth resistor R5. The voltameter 2 is connected in parallel to the sixth resistor R6 through an SRP pin and an SRN pin to obtain the current passing through the sixth resistor R6.

The calibration module further includes a controller. The controller is configured to determine a first calibration coefficient based on the loop current of the first calibration circuit 50 and the calibration current, and is further configured to determine a second calibration coefficient based on the loop current of the second calibration circuit 50 and the calibration current.

For example, the controller may be a personal computer (personal computer, PC) controller, and the calibration current is provided by the calibration power supply Vs. The PC controller calibrates, based on the calibration current, the loop current of the first calibration circuit 50 obtained by the voltameter 1, and determines the first calibration coefficient, to calibrate the voltameter 1; and may also calibrate, based on the calibration current, the loop current of the second calibration circuit 60 obtained by the voltameter 2, and determines the second calibration coefficient, to calibrate the voltameter 2.

The calibration system further includes a control module. The control module is connected to the collection module and is configured to obtain the loop current of the first calibration circuit 50 and the loop current of the second calibration circuit 60. The controller is connected to the control module to obtain the return current of the first calibration circuit 50 and the loop current of the second calibration circuit 60 through the control module.

Optionally, the control module may obtain the calibration current through the controller, determine the first calibration coefficient based on the calibration current and the loop current of the first calibration circuit 50, and determine the second calibration coefficient based on the calibration current and the loop current of the second calibration circuit 60.

For example, the control module is connected to the voltameter 2 through an I2C0 interface, is connected to the voltameter 1 through an I2C1 interface, and is connected to the PC controller through an I2C3 interface. The control module transmits the current obtained by the voltameter 2 to the PC controller, and transmits the current obtained by the voltameter 1 to the PC controller. The PC controller determines the second calibration coefficient based on the calibration current and the current obtained by the voltameter 2, and determines the first calibration coefficient based on the calibration current and the current obtained by the voltameter 1.

The controller is further configured to transmit the first calibration coefficient and the second calibration coefficient to the control module. The control module is further configured to store the first calibration coefficient and the second calibration coefficient. The first calibration coefficient may be used in the electronic device shown in FIG. 4(a). The control module shown in FIG. 4(a) stores the first calibration coefficient, and the control module may calibrate the charging current of the first cell Vcell 1 based on the first calibration coefficient. The second calibration coefficient may be used in the electronic device shown in FIG. 4(a). The control module shown in FIG. 4(a) stores the second calibration coefficient, and the control module may calibrate the charging current of the second cell Vcell 2 based on the second calibration coefficient.

For example, the calibration current obtained by the controller is 5 A, the loop current of the first calibration circuit obtained by the first collection module is 4 A, and the controller obtains the loop current of the first calibration circuit through the control module. The controller obtains a calibration coefficient 1.25 (5 A/4 A) through calculation based on the calibration current and the loop current of the first calibration circuit, transmits the calibration coefficient obtained through calculation to the control module, and stores the calibration coefficient in the control module. After the electronic device is delivered from the factory, the control module obtains a first current 6 A through the voltameter 1 shown in FIG. 4(a), and the control module determines, based on the calibration coefficient 1.25 obtained through calculation before delivery, that a more accurate first current is 7.5 A (6 A* 1.25). When the first current is the charging current of the first cell Vcell 1, the control module determines that the charging current of the first cell Vcell 1 is 7.5 A.

It should be noted that the control module may more accurately determine the charging current of each cell based on the calibration coefficient, to ensure charging safety of each cell.

Specifically, the first calibration circuit 50 further includes a first transistor Q1, the first transistor Q1 is connected in series to the calibration power supply Vs and the fifth resistor R5, and the first transistor Q1 is configured to control the first calibration circuit 50 to be disconnected or connected. The second calibration circuit 60 further includes a second transistor Q2, the second transistor Q2 is connected in series to the calibration power supply Vs and the sixth resistor R6, and the second transistor Q2 is configured to control the second calibration circuit 60 to be disconnected or connected. When the first transistor Q1 controls the first calibration circuit 50 to be connected and the second transistor Q2 controls the second calibration circuit 60 to be disconnected, the controller is specifically configured to determine the first calibration coefficient based on the loop current of the first calibration circuit 50 and the calibration current. When the first transistor Q1 controls the first calibration circuit 50 to be disconnected and the second transistor Q2 controls the second calibration circuit 60 to be connected, the controller is specifically configured to determine the second calibration coefficient based on the loop current of the second calibration circuit 60 and the calibration current.

It should be noted that, a transistor may control a calibration circuit to be connected or disconnected, so that the PC controller separately calibrates the voltameter 1 and the voltameter 2.

The first calibration circuit 50 further includes a seventh resistor R7. The seventh resistor R7 is connected in series to the calibration power supply Vs, the fifth resistor R5, and the first transistor Q1. The seventh resistor R7 is configured to adjust the loop current of the first calibration circuit 50.

The second calibration circuit further includes an eighth resistor R8. The eighth resistor R8 is connected in series to the calibration power supply Vs, the sixth resistor R6, and the second transistor Q2. The eighth resistor R8 is configured to adjust the loop current of the second calibration circuit 60.

The calibration system provided in this embodiment of this application includes the calibration module. The calibration module may calibrate the collection module configured to obtain a charging current of a cell, so that the charging current of each cell can be more accurately determined.

It should be noted that, in the diagram of the structure of the electronic device shown in FIG. 4(a), it is not difficult to learn that, in the collection module, the voltameter 1 may directly obtain the charging current of the first cell Vcell 1, the voltameter 2 obtains the total charging current of the battery module, and the charging current of the second cell Vcell 2 further needs to be determined by the control module based on the total charging current of the battery module obtained by the voltameter 2 and the charging current of the first cell Vcell 1 obtained by the voltameter 1.

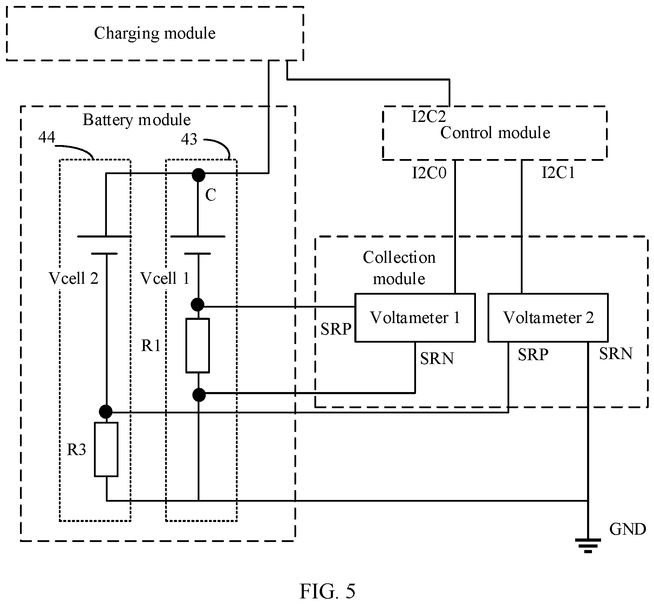

Further, to facilitate the control module in controlling the total charging current, FIG. 5 is a diagram of a structure of an electronic device according to an embodiment of this application. A collection module in FIG. 5 may directly obtain a charging current of a first cell Vcell 1 and a charging current of a second cell Vcell 2, so that a step of obtaining a charging current of one of cells through calculation based on a total charging current and a charging current of the other cell is saved for a control module. The electronic device includes a charging module, a battery module, the collection module, and the control module.

The charging module is connected to a first end (end C) of the battery module and is configured to provide the total charging current for the battery module.

The battery module includes a first branch 43 and a second branch 44. The first branch 43 is connected in parallel to the second branch 44, the first branch 43 includes the first cell Vcell 1 and a first resistor R1 that are connected in series, and the second branch 44 includes the second cell Vcell 2.

The collection module includes a first collection module and a second collection module. The first collection module is connected in parallel to the first resistor R1 to obtain a first current. The first current is the charging current of the first cell Vcell 1. The second collection module is configured to obtain a second current.

The control module is connected to the charging module and is configured to control, based on the first current and the second current, the total charging current provided by the charging module.

Optionally, the second branch 44 further includes a third resistor R3 connected in series to the second cell Vcell 2, the second collection module is connected in parallel to the third resistor R3, and the second current is the charging current of the second cell Vcell 2.

It should be noted that the first resistor R1 and the third resistor R3 may be collection resistors. A current passing through the first resistor R1 is the charging current of the first cell Vcell 1, and a current passing through the third resistor R3 is the charging current of the second cell Vcell 2.

For example, the first collection module is a voltameter 1, and the second collection module is a voltameter 2. The voltameter 1 is connected in parallel to the first resistor R1 through an SRP pin and an SRN pin to obtain the current passing through the second resistor R1. The voltameter 2 is connected in parallel to the third resistor R3 through an SRP pin and an SRN pin to obtain the current passing through the third resistor R3.

The control module is connected to the collection module to obtain the first current and the second current. The control module is specifically configured to control, based on the charging current of the first cell Vcell 1 and the charging current of the second cell Vcell 2, the total charging current provided by the charging module.

For example, the control module is connected to the voltameter 1 through an I2C0 interface and is connected to the voltameter 2 through an I2C1 interface. The control module determines that the current obtained by the voltameter 1 is the charging current of the first cell Vcell 1, and determines that the current obtained by the voltameter 2 is the charging current of the second cell Vcell 2. The control module stores a current threshold of the first cell Vcell 1 and a current threshold of the second cell Vcell 2. The current threshold of the first cell Vcell 1 is a safety threshold of the first cell Vcell 1, and may be understood as a maximum charging current value of the first cell Vcell 1; and the current threshold of the second cell Vcell 2 is a safety threshold of the second cell Vcell 2, and may be understood as a maximum charging current value of the second cell Vcell 2. The control module may determine whether the charging current of the first cell Vcell 1 exceeds the safety threshold of the first cell Vcell 1, and determine whether the charging current of the second cell Vcell 2 exceeds the safety threshold of the second cell Vcell 2.

It should be noted that, the control module determines whether a charging current of each cell in the battery module exceeds a safety threshold of the cell, to maximize the total charging current of the battery module while ensuring charging safety of each cell in the battery module, thereby improving charging efficiency.

When the control module determines that the charging current of the first cell Vcell 1 is greater than a first current threshold and the charging current of the second cell Vcell 2 is less than or equal to a second current threshold, the control module is specifically configured to control the charging module to reduce the total charging current. When the control module determines that the charging current of the first cell Vcell 1 is less than or equal to a first current threshold and the charging current of the second cell Vcell 2 is greater than a second current threshold, the control module is specifically configured to control the charging module to reduce the total charging current. When the control module determines that the charging current of the first cell Vcell 1 is greater than a first current threshold and the charging current of the second cell Vcell 2 is greater than a second current threshold, the control module is specifically configured to control the charging module to reduce the total charging current.

It should be noted that a specific manner of reducing the total charging current by the control module is described above. To avoid redundancy, details are not described herein again.

When the control module determines that the charging current of the first cell Vcell is less than the first current threshold and the charging current of the second cell Vcell 2 is less than the second current threshold, the control module is specifically configured to control the charging module to increase the total charging current.

It should be noted that a specific manner of increasing the total charging current by the control module is described above. To avoid redundancy, details are not described herein again.

The first current threshold is the safety threshold of the first cell Vcell 1, and the second current threshold is the safety threshold of the second cell Vcell 2.

For example, the charging module is connected to the battery module to provide the total charging current, and is connected to an I2C2 interface of the control module to control the total charging current under control of the control module.

It should be noted that, in diagram of structures of electronic devices shown in FIG. 4(a) and FIG. 5, two cells are connected in parallel in the battery module. A quantity of cells connected in parallel in the battery module is not limited in this embodiment of this application. More cells may be disposed in the battery module based on actual internal space of the electronic device and an actual capacity requirement. The following describes a structure of an electronic device by using an example in which three cells are connected in parallel.

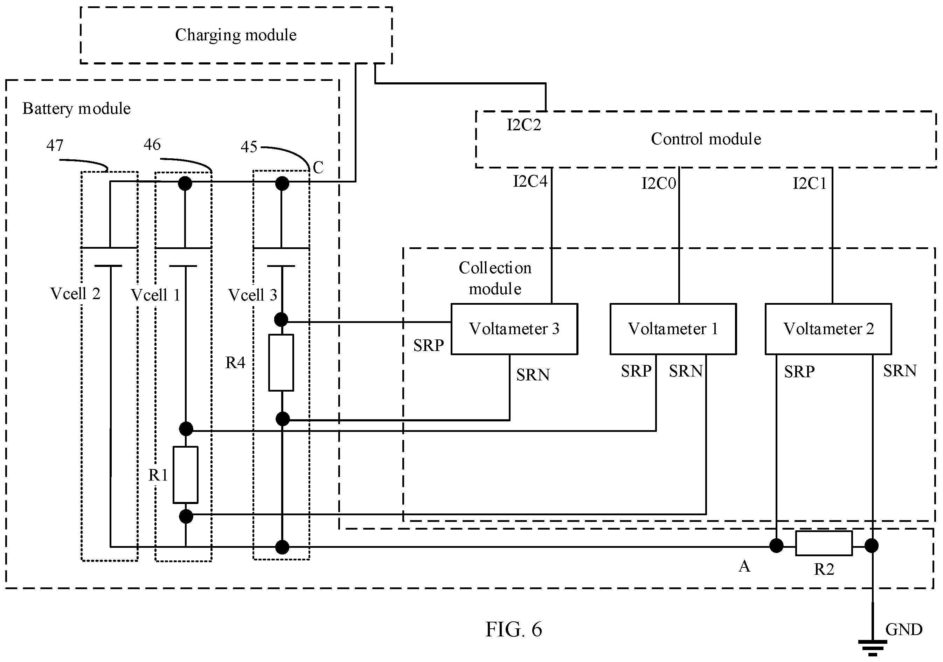

FIG. 6 is a diagram of a structure of an electronic device according to an embodiment of this application. A battery module in FIG. 6 includes three cells connected in parallel. The electronic device includes a charging module, a battery module, a collection module, and a control module.

The charging module is connected to a first end (end C) of the battery module and is configured to provide a total charging current for the battery module.

The battery module includes a first branch 46, a second branch 47, and at least one third branch 45. The first branch 46, the second branch 47, and the at least one third branch 45 are connected in parallel, the first branch 46 includes a first cell Vcell 1 and a first resistor R1 that are connected in series, the second branch 47 includes a second cell Vcell 2, and each of the at least one third branch 45 includes a third cell Vcell 3 and a fourth resistor R4 that are connected in series.

The collection module includes a first collection module, a second collection module, and a third collection module. The first collection module is connected in parallel to the first resistor R1 to obtain a first current. The first current is a charging current of the first cell Vcell 1. The second collection module is configured to obtain a second current. The third collection module is connected in parallel to the fourth resistor R4 to obtain a third current. The third current is a charging current of the third cell Vcell 3.

The control module is connected to the charging module and is configured to control, based on the first current, the second current, and the third current, the total charging current provided by the charging module.

Optionally, the battery module further includes a second resistor R2, a first end (end A) of the first branch 46, a first end (end A) of the second branch 47, and a first end (end A) of the at least one third branch 45 are connected to a first end of the second resistor R2, a second end of the second resistor R2 is grounded, the second collection module is connected in parallel to the second resistor R2, and the second current is the total charging current.

It should be noted that the first resistor R1, the second resistor R2, and the fourth resistor R4 may be collection resistors. A current passing through the first resistor R1 is the charging current of the first cell Vcell 1, a current passing through the second resistor R2 is the total charging current of the battery module, and a current passing through the fourth resistor R4 is the charging current of the third cell Vcell 3.

For example, the first collection module is a voltameter 1, the second collection module is a voltameter 2, and the third collection module is a voltameter 3. The voltameter 1 is connected in parallel to the second resistor R1 through an SRP pin and an SRN pin to obtain the current passing through the first resistor R1. The voltameter 2 is connected in parallel to the second resistor R2 through an SRP pin and an SRN pin to obtain the current passing through the second resistor R2. The voltameter 3 is connected in parallel to the fourth resistor R4 through an SRP pin and an SRN pin to obtain the current passing through the fourth resistor R4.

The control module is connected to the collection module to obtain the first current and the second current. The control module is specifically configured to control, based on the charging current of the first cell Vcell 1, a charging current of the second cell Vcell 2, and the charging current of the third cell Vcell 3, the total charging current provided by the charging module.

For example, the control module is connected to the voltameter 1 through an I2C0 interface, is connected to the voltameter 2 through an I2C1 interface, and is connected to the voltameter 3 through an I2C4 interface. The control module determines the current obtained by the voltameter 1 as the charging current of the first cell Vcell 1, determines the current obtained by the voltameter 3 as the charging current of the third cell Vcell 3, and determines the charging current of the second cell Vcell 2 based on the current obtained by the voltameter 2, the current obtained by the voltameter 1, and the current obtained by the voltameter 3. The control module stores a current threshold of the first cell Vcell 1, a current threshold of the second cell Vcell 2, and a current threshold of the third cell Vcell 3. The current threshold of the first cell Vcell 1 is a safety threshold of the first cell Vcell 1, and may be understood as a maximum charging current value of the first cell Vcell 1; the current threshold of the second cell Vcell 2 is a safety threshold of the second cell Vcell 2, and may be understood as a maximum charging current value of the second cell Vcell 2; and the current threshold of the third cell Vcell 3 is a safety threshold of the third cell Vcell 3, and may be understood as a maximum charging current value of the third cell Vcell 3. The control module may determine whether the charging current of the first cell Vcell 1 exceeds the safety threshold of the first cell Vcell 1, determine whether the charging current of the second cell Vcell 2 exceeds the safety threshold of the second cell Vcell 2, and determine whether the charging current of the third cell Vcell 3 exceeds the safety threshold of the third cell Vcell 3.

It should be noted that, the control module determines whether a charging current of each cell in the battery module exceeds a safety threshold of the cell, to maximize the total charging current of the battery module while ensuring charging safety of each cell in the battery module, thereby improving charging efficiency.

When the control module determines that the charging current of the first cell Vcell 1 is greater than a first current threshold, the control module is specifically configured to control the charging module to reduce the total charging current; and/or when the control module determines that the charging current of the second cell Vcell 2 is greater than a second current threshold, the control module is specifically configured to control the charging module to reduce the total charging current; and/or when the control module determines that the charging current of the third cell Vcell 3 is greater than a third current threshold, the control module is specifically configured to control the charging module to reduce the total charging current.

It should be noted that a specific manner of reducing the total charging current by the control module is described above. To avoid redundancy, details are not described herein again.

When the control module determines that the charging current of the first cell Vcell 1 is less than the first current threshold, the charging current of the second cell Vcell 2 is less than the second current threshold, and the charging current of the third cell Vcell 3 is less than a third current threshold, the control module is specifically configured to control the charging module to increase the total charging current.

It should be noted that a specific manner of increasing the total charging current by the control module is described above. To avoid redundancy, details are not described herein again.

The first current threshold is the safety threshold of the first cell Vcell 1, the second current threshold is the safety threshold of the second cell Vcell 2, and the third current threshold is the safety threshold of the third cell Vcell 3.

For example, the charging module is connected to the battery module to provide the total charging current, and is connected to an I2C2 interface of the control module to control the total charging current under control of the control module.

It is not difficult to learn that, based on the electronic device shown in FIG. 4(a), the third cell is added to the electronic device shown in FIG. 6, and the voltameter 3 in the collection module may directly collect the charging current of the third cell. It may be understood that, when the battery module includes N (N is a positive integer greater than or equal to 2) cells that are connected in parallel, a charging current of each cell in the battery module may be determined by obtaining a total charging current of the N cells and respectively obtaining charging currents of N-1 cells by the collection module.

Certainly, in the electronic device shown in FIG. 5, a quantity of cells connected in parallel may also be increased, and correspondingly, a quantity of voltameters in the collection module may be increased, so that each voltameter in the collection module may directly obtain a charging current of each cell.

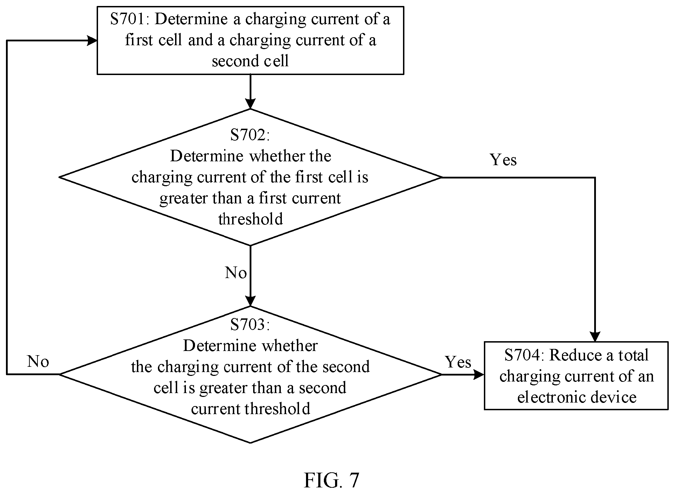

Based on an electronic device of the foregoing structure, FIG. 7 is a schematic flowchart of a control method according to an embodiment of this application. The control method 700 may be applied to the electronic device described above, so that charging efficiency can be improved while charging safety of each cell in the battery module is ensured. The following describes the method 700 in detail by using an example in which the method 700 is applicable to the electronic device shown in FIG. 4(a) or the electronic device shown in FIG. 5.

S701: Determine a charging current of a first cell and a charging current of a second cell.

Optionally, when the electronic device is a structure shown in FIG. 4(a), a total charging current of at least two cells and the charging current of the first cell are first obtained, and then the charging current of the second cell is determined based on the total charging current of the at least two cells and the charging current of the first cell.

Optionally, when the electronic device is a structure shown in FIG. 5, the charging current of the first cell and the charging current of the second cell may be directly obtained.

It should be noted that a control module in the electronic device is configured to determine the charging current of the first cell and the charging current of the second cell.

For example, a charging current of each cell in the battery module may be determined based on charging currents of two cells and a charging current of one of the cells.

It should be noted that, if the battery module includes N (N is a positive integer greater than) cells, a total charging current of the N cells and charging currents of N-1 cells may be obtained, to determine charging currents of all the cells in the battery module.

To more accurately determine the charging current of each cell, the control module stores calibration coefficients, and the control module may calibrate the charging current of each cell based on the charging current of each cell obtained from a collection module and a corresponding calibration coefficient.

It should be noted that the control module may control a total charging current of the electronic device based on the charging current of the first cell and/or the charging current of the second cell, where the total charging current of the electronic device may be understood as a total charging current provided by a charging module for the battery module.

To be specific, the control module determines the charging current of each cell in the battery module, and needs to determine whether the charging current of each cell is within a safety threshold. When a charging current of any cell exceeds a safety threshold, the total charging current needs to be controlled.

For example, whether the charging current of each cell is within the safety threshold may be determined based on a sequence of the following steps.

S702: Determine whether the charging current of the first cell is greater than a first current threshold.

For example, when the control module determines that the charging current of the first cell is greater than the first current threshold, it indicates that the charging current of the first cell exceeds a safety threshold of the first cell. In this case, under control of the control module, the charging module performs step S705.

For example, when the control module determines that the charging current of the first cell is less than or equal to the first current threshold, it indicates that the charging current of the first cell is within a safety threshold of the first cell. In this case, the control module may continue to perform step S704 to determine whether the charging current of the second cell is within a safety threshold.

S703: Determine whether the charging current of the second cell is greater than a second current threshold.

For example, when the control module determines that the charging current of the second cell is greater than the second current threshold, it indicates that the charging current of the second cell exceeds the safety threshold of the second cell. In this case, under control of the control module, the charging module performs step S705.

For example, when the control module determines that the charging current of the first cell is less than or equal to the first current threshold and the control module determines that the charging current of the second cell is less than or equal to the second current threshold, it indicates that the charging current of the first cell is within the safety threshold of the first cell and the charging current of the second cell is within the safety threshold of the second cell. In this case, the control module may not need to control the charging module to reduce the total charging current of the electronic device.

S704: Reduce the total charging current of the electronic device.

For example, when the charging current of the first cell is greater than the first current threshold and the charging current of the second cell is less than or equal to the second current threshold, the total charging current of the electronic device is reduced. When the charging current of the first cell is less than or equal to the first current threshold and the charging current of the second cell is greater than the second current threshold, the total charging current of the electronic device is reduced. When the charging current of the first cell is greater than the first current threshold and the charging current of the second cell is greater than the second current threshold, the total charging current of the electronic device is reduced.

In an implementation, when the charging current of the first cell is less than the first current threshold and the charging current of the second cell is less than the second current threshold, the total charging current is increased.

It should be noted that the total charging current of the electronic device may be controlled based on a ratio of current charging currents of the cells.

For example, it is assumed that the first current threshold is 7 A, the second current threshold is 10 A, the current charging current of the first cell Vcell 1 is 8 A, and the current charging current of the second cell Vcell 2 is 6 A. The control module determines that the charging current of the first cell Vcell 1 is greater than the first current threshold and the charging current of the second cell Vcell 2 is less than the second current threshold. In this case, a ratio of an actual charging current of the first cell Vcell 1 to an actual charging current of the second cell Vcell 2 is 4/3 (8:6), and the total charging current is 14 A (8 A+6 A). To ensure charging safety, the actual charging current of the first cell Vcell 1 needs to be reduced to below the first current threshold 7 A. The control module may learn, through calculation based on the ratio of actual charging currents, that when the actual charging current of the first cell Vcell 1 is 7 A, the actual charging current of the second cell Vcell 2 is 5.25 A (6*7/8). In this case, the total charging current is 12.25 A (7 A+5.25 A). That is, the control module may control, based on the ratio of the charging currents of the cells, the total charging current to be reduced from 14 A to 12.25 A.

For another example, it is assumed that the first current threshold is 7 A, the second current threshold is 10 A, the current charging current of the first cell Vcell 1 is 6 A, and the current charging current of the second cell Vcell 2 is 8 A. The control module determines that the charging current of the first cell Vcell 1 is less than the first current threshold and the charging current of the second cell Vcell 2 is less than the second current threshold. In this case, a ratio of an actual charging current of the first cell Vcell 1 to an actual charging current of the second cell Vcell 2 is 3/4 (6:8), and the total charging current is 14 A (8 A+6 A). The charging current of the first cell Vcell 1 is closer to the first current threshold. Therefore, to improve charging to be less than, a current value that needs to be increased for the actual charging current of the second cell Vcell 2 may be obtained through calculation based on a reference that the actual charging current of the first cell Vcell 1 needs to be increased to the first current threshold 7A. The control module learns, through calculation based on the ratio of actual charging currents, that when the actual charging current of the first cell Vcell 1 is 7 A, the actual charging current of the second cell Vcell 2 is 9.3 A (7*8/6). In this case, the total charging current is 16.3 A (7 A+9.3 A). That is, the control module may control, based on the ratio of the charging currents of the cells, the total charging current to be increased from 14 A to 16.3 A.

Based on the foregoing solution, the charging current of each cell in the electronic device is obtained, and whether the charging current of each cell is within the safety threshold is determined, so that cell charging safety of each cell can be ensured.

It should be noted that, to enable the electronic device to more accurately determine whether the charging current of each cell is within the safety threshold, a calibration coefficient may be introduced. The electronic device may more accurately determine the charging current of each cell based on the calibration coefficient, to more accurately control the total charging current.

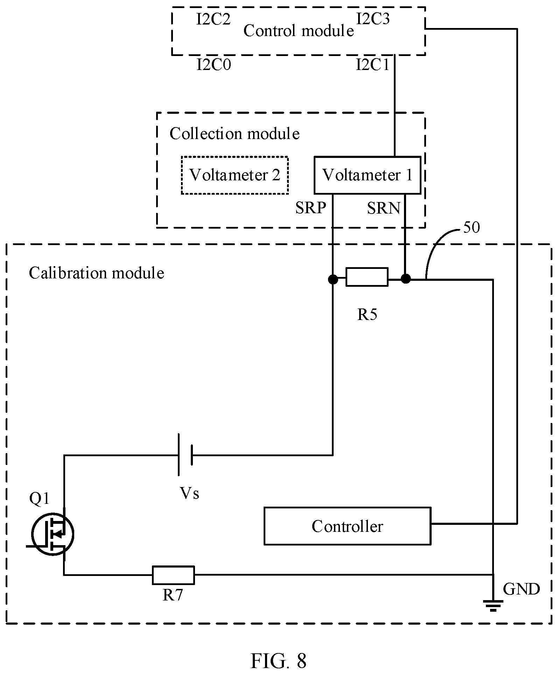

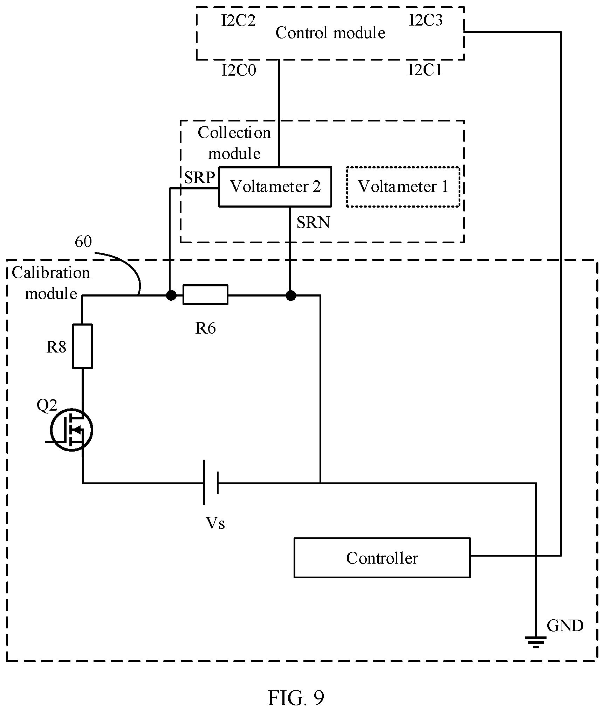

The calibration system shown in FIG. 4(b) A may be used to calibrate a current obtained by the collection module. It can be learned from the foregoing description of the calibration system shown in FIG. 4(b) that the calibration system may include a first calibration circuit 50 and a second calibration circuit 60. The first calibration circuit 50 includes a first transistor Q1, and the first transistor Q1 is configured to control the first calibration circuit 50 to be disconnected or connected. The second calibration circuit 60 includes a second transistor Q2, and the second transistor Q2 is configured to control the second calibration circuit 60 to be disconnected or connected. A PC controller may separately calibrate charging currents obtained by the first collection module and the second collection module. The following separately describes two calibration modes of the calibration system with reference to FIG. 8 and FIG. 9.

FIG. 8 is a diagram of a structure of a calibration system according to an embodiment of this application. A first calibration circuit 50 of the calibration system is connected, and a current obtained by a first collection module (a voltameter 1) may be calibrated. The calibration system corresponds to a calibration mode for calibrating the first collection module (the voltameter 1), and the calibration system includes a collection module and a calibration module.

The collection module includes the first collection module (the voltameter 1). The calibration module includes the first calibration circuit 50. The first calibration circuit 50 is configured to calibrate the first collection module. The first calibration circuit 50 includes a calibration power supply Vs and a fifth resistor R5 that are connected in series. The calibration power supply Vs is configured to provide a calibration current. The first collection module is connected in parallel to the fifth resistor R5 to obtain a loop current of the first calibration circuit 50.

It should be noted that the fifth resistor R5 may be a collection resistor. A current passing through the fifth resistor R5 is the loop current of the first calibration circuit 50.

For example, the voltameter 1 is connected in parallel to the fifth resistor R5 through an SRP pin and an SRN pin to obtain the current passing through the fifth resistor R5.

The calibration module further includes a controller. The controller is configured to determine a first calibration coefficient based on the loop current of the first calibration circuit 50 and the calibration current.

For example, the controller may be a PC controller, and the calibration current is provided by the calibration power supply Vs. The PC controller calibrates, based on the calibration current, the loop current of the first calibration circuit 50 obtained by the voltameter 1, and determines the first calibration coefficient, to calibrate the voltameter 1.

The calibration system further includes a control module. The control module is connected to the first collection module and is configured to obtain the return current of the first calibration circuit 50. The controller is connected to the control module to obtain the loop current of the first calibration circuit 50 through the control module.

For example, the control module is connected to the voltameter 1 through an I2C1 interface and is connected to the PC controller through an I2C3 interface. The control module transmits the current obtained by the voltameter 1 to the PC controller, and the PC controller determines the first calibration system quantity based on the calibration current and the current obtained by the voltameter 1.

The controller is further configured to transmit the first calibration coefficient to the control module, and the control module is further configured to store the first calibration coefficient.

The first calibration circuit 50 further includes a first transistor Q1. The first transistor Q1 is connected in series to the calibration power supply Vs and the fifth resistor R5. The first transistor Q1 is configured to control the first calibration circuit 50 to be disconnected or connected. When the first transistor Q1 controls the first calibration circuit 50 to be connected, the controller is specifically configured to determine the first calibration coefficient based on the loop current of the first calibration circuit 50 and the calibration current.

The first calibration circuit 50 further includes a seventh resistor R7. The seventh resistor R7 is connected in series to the calibration power supply Vs, the fifth resistor R5, and the first transistor Q1. The seventh resistor R7 is configured to adjust the loop current of the first calibration circuit 50.

FIG. 9 is a diagram of a structure of a calibration system according to an embodiment of this application. A second calibration circuit 60 of the calibration system is connected, and a current obtained by a second collection module (a voltameter 2) may be calibrated. The calibration system corresponds to a calibration mode for calibrating the second collection module (the voltameter 2), and the calibration system includes a collection module and a calibration module.

The collection module includes the second collection module (the voltameter 2). The calibration module includes the second calibration circuit 60. The second calibration circuit 60 is configured to calibrate the second collection module. The second calibration circuit 60 includes a calibration power supply Vs and a sixth resistor R6 that are connected in series. The calibration power supply Vs is configured to provide a calibration current. The second collection module is connected in parallel to the sixth resistor R6 to obtain a loop current of the second calibration circuit 60.

It should be noted that the sixth resistor R6 may be a collection resistor. A current passing through the sixth resistor R6 is the loop current of the second calibration circuit 60.

For example, the voltameter 2 is connected in parallel to the sixth resistor R6 through an SRP pin and an SRN pin to obtain the current passing through the sixth resistor R6.

The calibration module further includes a controller. The controller is configured to determine a second calibration coefficient based on the loop current of the second calibration circuit 60 and the calibration current.

For example, the controller may be a PC controller, and the calibration current is provided by the calibration power supply Vs. The PC controller calibrates, based on the calibration current, the loop current of the second calibration circuit 60 obtained by the voltameter 2, and determines the second calibration coefficient, to calibrate the voltameter 2.

The calibration system further includes a control module. The control module is connected to the second collection module and is configured to obtain the loop current of the second calibration circuit 60. The controller is connected to the control module to obtain the loop current of the second calibration circuit 60 through the control module.

For example, the control module is connected to the voltameter 2 through an I2C0 interface and is connected to the PC controller through an I2C3 interface. The control module transmits the current obtained by the voltameter 2 to the PC controller, and the PC controller determines the second calibration coefficient based on the calibration current and the current obtained by the voltameter 2.

The controller is further configured to transmit the second calibration coefficient to the control module, and the control module is further configured to store the second calibration coefficient.

The second calibration circuit 60 further includes a second transistor Q2. The second transistor Q2 is connected in series to the calibration power supply Vs and the sixth resistor R6, and the second transistor Q2 is configured to control the second calibration circuit to be disconnected or connected. When the second transistor Q2 controls the second calibration circuit 60 to be connected, the controller is specifically configured to determine the second calibration coefficient based on the loop current of the second calibration circuit 60 and the calibration current.

The second calibration circuit 60 further includes an eighth resistor R8. The eighth resistor R8 is connected in series to the calibration power supply Vs, the sixth resistor R6, and the second transistor Q2, and the eighth resistor R8 is configured to adjust the loop current of the second calibration circuit 60.

Based on the foregoing solution, this application provides a calibration system, to calibrate modules that are in a collection module and that are respectively configured to obtain charging currents of cells, to more accurately determine whether the charging currents of the cells are within safety thresholds.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device, comprising:
a charging module, wherein the charging module is connected to a first end of a battery module and is configured to provide a total charging current for the battery module;
the battery module, comprising a first branch and a second branch, wherein the first branch is connected in parallel to the second branch, the first branch comprises a first cell and a first resistor that are connected in series, and the second branch comprises a second cell;
a collection module, wherein the collection module comprises a first collection module and a second collection module, the first collection module is connected in parallel to the first resistor to obtain a first current, the first current is a charging current of the first cell, the second collection module is configured to obtain a second current, and the second current is a charging current of the second cell or the total charging current; and
a control module, connected to the charging module and configured to control, based on the first current and the second current, the total charging current provided by the charging module.

2. The electronic device according to claim 1, wherein
the battery module further comprises a second resistor, both a first end of the first branch and a first end of the second branch are connected to a first end of the second resistor, a second end of the second resistor is grounded, the second collection module is connected in parallel to the second resistor, and the second current is the total charging current.

3. The electronic device according to claim 1, wherein
the second branch further comprises a third resistor connected in series to the second cell, the second collection module is connected in parallel to the third resistor, and the second current is the charging current of the second cell.

4. The electronic device according to any one of claims 1 to 3, wherein
the control module is connected to the collection module to obtain the first current and the second current; and
the control module is specifically configured to control, based on the charging current of the first cell and the charging current of the second cell, the total charging current provided by the charging module.

5. The electronic device according to any one of claims 1 to 4, wherein
when the control module determines that the charging current of the first cell is greater than a first current threshold and the charging current of the second cell is less than or equal to a second current threshold, the control module is specifically configured to control the charging module to reduce the total charging current;
when the control module determines that the charging current of the first cell is less than or equal to the first current threshold and the charging current of the second cell is greater than the second current threshold, the control module is specifically configured to control the charging module to reduce the total charging current; or
when the control module determines that the charging current of the first cell is greater than the first current threshold and the charging current of the second cell is greater than the second current threshold, the control module is specifically configured to control the charging module to reduce the total charging current.

6. The electronic device according to any one of claims 1 to 5, wherein
when the control module determines that the charging current of the first cell is less than the first current threshold and the charging current of the second cell is less than the second current threshold, the control module is specifically configured to control the charging module to increase the total charging current.

7. The electronic device according to claim 2, wherein
the battery module further comprises at least one third branch, each of the at least one third branch comprises a third cell and a fourth resistor that are connected in series, and the third branch is connected in parallel to the first branch and is connected in parallel to the second branch;
the collection module further comprises a third collection module, the third collection module is connected in parallel to the fourth resistor to obtain a third current, and the third current is a charging current of the third cell; and
the control module is configured to control, based on the first current, the second current, and the third current, the total charging current provided by the charging module.

8. The electronic device according to claim 7, wherein
the control module is connected to the collection module to obtain the first current, the second current, and the third current; and
the control module is specifically configured to control, based on the charging current of the first cell, the charging current of the second cell, and the charging current of the third cell, the total charging current provided by the charging module.

9. The electronic device according to any one of claims 1 to 8, wherein the battery module comprises a first region and a second region, the first region is used for disposing the first cell, the second region is used for disposing the second cell, and a size of the first cell is different from a size of the second cell, to form a vacant region in the electronic device.

10. A calibration system, comprising:
an electronic device, wherein the electronic device comprises a collection module, and the collection module comprises a first collection module and a second collection module; and
a calibration module, wherein the calibration module comprises a first calibration circuit and a second calibration circuit, the first calibration circuit comprises a calibration power supply and a fifth resistor that are connected in series, the second calibration circuit comprises the calibration power supply and a sixth resistor that are connected in series, the second calibration circuit is connected in parallel to the first calibration circuit, and the calibration power supply is configured to provide a calibration current; and
the first collection module is connected in parallel to the fifth resistor to obtain a loop current of the first calibration circuit, and the second collection module is connected in parallel to the sixth resistor to obtain a loop current of the second calibration circuit.

11. The calibration system according to claim 10, wherein
the calibration module further comprises a controller, the controller is configured to determine a first calibration coefficient based on the loop current of the first calibration circuit and the calibration current, and is further configured to determine a second calibration coefficient based on the loop current of the second calibration circuit and the calibration current.

12. The calibration system according to claim 11, wherein the calibration system further comprises:
a control module, wherein the control module is connected to the collection module and is configured to obtain the loop current of the first calibration circuit and the loop current of the second calibration circuit; and
the controller is connected to the control module to obtain the loop current of the first calibration circuit and the loop current of the second calibration circuit through the control module.

13. The calibration system according to claim 12, wherein
the controller is further configured to transmit the first calibration coefficient and the second calibration coefficient to the control module; and
the control module is further configured to store the first calibration coefficient and the second calibration coefficient, the first calibration coefficient is used to calibrate a first current, the first current is a charging current of a first cell, the second calibration coefficient is used to calibrate a second current, and the second current is a charging current of a second cell or a total charging current of the electronic device.

14. The calibration system according to any one of claims 11 to 13, wherein
the first calibration circuit further comprises a first transistor, the first transistor is connected in series to the calibration power supply and the fifth resistor, and the first transistor is configured to control the first calibration circuit to be disconnected or connected;
the second calibration circuit further comprises a second transistor, the second transistor is connected in series to the calibration power supply and the sixth resistor, and the second transistor is configured to control the second calibration circuit to be disconnected or connected; and
when the first transistor controls the first calibration circuit to be connected and the second transistor controls the second calibration circuit to be disconnected, the controller is specifically configured to determine the first calibration coefficient based on the loop current of the first calibration circuit and the calibration current; or
when the first transistor controls the first calibration circuit to be disconnected and the second transistor controls the second calibration circuit to be connected, the controller is specifically configured to determine the second calibration coefficient based on the loop current of the second calibration circuit and the calibration current.

15. The calibration system according to claim 14, wherein
the first calibration circuit further comprises a seventh resistor, the seventh resistor is connected in series to the calibration power supply, the fifth resistor, and the first transistor, and the seventh resistor is configured to adjust the loop current of the first calibration circuit; and
the second calibration circuit further comprises an eighth resistor, the eighth resistor is connected in series to the calibration power supply, the sixth resistor, and the second transistor, and the eighth resistor is configured to adjust the loop current of the second calibration circuit.

16. A control method, wherein the method is applied to an electronic device, the electronic device comprises at least two cells connected in parallel, the at least two cells comprise a first cell and a second cell, and the method comprises:
determining a charging current of the first cell and a charging current of the second cell; and
controlling a total charging current of the electronic device based on the charging current of the first cell and/or the charging current of the second cell.

17. The method according to claim 16, wherein determining the charging current of the first cell and the charging current of the second cell comprises:
obtaining a total charging current of the at least two cells and the charging current of the first cell; and
determining the charging current of the second cell based on the total charging current of the at least two cells and the charging current of the first cell.

18. The method according to claim 16, wherein determining the charging current of the first cell and the charging current of the second cell comprises:
obtaining the charging current of the first cell and the charging current of the second cell.

19. The method according to any one of claims 16 to 18, wherein controlling the total charging current of the electronic device based on the charging current of the first cell and/or the charging current of the second cell comprises:
when the charging current of the first cell is greater than a first current threshold and the charging current of the second cell is less than or equal to a second current threshold, reducing the total charging current of the electronic device;
when the charging current of the first cell is less than or equal to the first current threshold and the charging current of the second cell is greater than the second current threshold, reducing the total charging current of the electronic device; or
when the charging current of the first cell is greater than the first current threshold and the charging current of the second cell is greater than the second current threshold, reducing the total charging current.

20. The method according to any one of claims 16 to 19, wherein controlling the total charging current of the electronic device based on the charging current of the first cell and/or the charging current of the second cell comprises:
when the charging current of the first cell is less than the first current threshold and the charging current of the second cell is less than the second current threshold, increasing the total charging current.

21. A computer-readable storage medium, wherein the computer-readable storage medium stores a computer program, and when the computer program is executed by a computer, the computer is enabled to implement the method according to any one of claims 16 to 20.

22. A computer program product comprising instructions, wherein when the computer program product is run on a computer, the computer is enabled to perform the method according to any one of claims 16 to 20.

23. A chip, wherein the chip comprises a processor and a data interface, and the processor reads, through the data interface, instructions stored in a memory, to perform the method according to any one of claims 16 to 20.
